# EUROPÄISCHE PATENTSCHRIFT

(11) **EP 0 805 619 B1**
(45) Veröffentlichungstag und Bekanntmachung des Hinweises auf die Patenterteilung: **21.02.2001**
(21) Anmeldenummer: 97105473.9
(22) Anmeldetag: 02.04.1997
(51) Int. Cl.: H05K 9/00

(54) **Abschirm-Formteil für elektronische Bauelemente**
Molded shielding cap for electrical components
Capot de blindage moulé pour des composants électriques

(30) Priorität: 03.05.1996 DE 19617656
(43) Veröffentlichungstag der Anmeldung: 05.11.1997
(73) Patentinhaber: Siegfried Schaal Metallveredelung GmbH & Co., 72517 Sigmaringendorf (DE)
(72) Erfinder: Schaal, Siegfried, 72517 Sigmaringendorf (DE)
(74) Vertreter: Ostertag, Ulrich

(56) Entgegenhaltungen:
- EP-A- 0 213 762
- EP-A- 0 597 670
- WO-A-95/34423
- DE-U- 8 910 862
- FR-A- 1 401 652
- FR-A- 2 647 610
- US-A- 5 150 282

## Beschreibung

Die Erfindung betrifft ein Abschirm-Formteil für elektronische Bauelemente nach dem Oberbegriff des Anspruches 1 sowie ein Verfahren zu dessen Herstellung.

Um elektronische, elektrische, magnetische oder elektromagnetische Bauelemente vor Fremdfeldern und -strahlungen, die Störungen hervorrufen können, zu schützen, werden die die Bauelemente aufnehmenden Gehäuse, beispielsweise die Gehäuseteile eines Fernsprechapparates, vielfach auf der Innenseite mit einer abschirmenden metallischen oder Metall enthaltenden Beschichtung versehen. Dies bedeutet, daß verhältnismäßig große Oberflächen zu beschichten sind, was teuer ist. Darüber hinaus ist die Abschirmwirkung derartiger Beschichtungen eingeschränkt, da die Gehäuseteile mitunter größere Öffnungen aufweisen, durch welche Störstrahlung oder störende Felder zu elektronischen Bauelementen gelangen können. Vor allem aber ist von Nachteil, daß die Aufbringung der Beschichtungen häufig deshalb zeitaufwendig und kostspielig ist, weil die Gehäuse besonders zu behandeln sind.

Aus diesem Grunde ist es bereits bekannt (vgl. z.B. WO 95/34423 A1 oder EP 0 597 670 A1), Abschirm-Formteile der im Oberbegriff des Anspruchs 1 angegebenen Art bereitzustellen, die aus einem thermoplastisch verformbaren Kunststoff-Formteil bestehen und auf der Innenwand und/oder Außenwand ganz oder teilweise mit einer elektrisch leitenden Beschichtung versehen sind. Erfindungsgemäß wird nicht der gesamte Innenraum des jeweiligen elektrischen oder elektronischen Gerätes, z.B. also des Fernsprechapparates, abgeschirmt; vielmehr wird im Innenraum dieses Gehäuses nur diejenige Gruppe bzw. diejenigen Gruppen von Bauelementen durch speziell zugeordnete Abschirm-Formteile vor Störstrahlungen geschützt, die einer solchen Abschirmung bedürfen.

Bei derartigen Abschirm-Formteilen stellt sich jedoch das Problem, wie diese in ihren Randbereichen mechanisch zusammengehalten und hier eine zuverlässige elektrische Verbindung geschaffen wird. Bei dem in der WO 95/34423 A1 beschriebenen Abschirm-Formteil geschieht dies dadurch, daß auf ein Folienlaminat, welches eine Metallschicht enthält, ein Kunststoffträger aufgespritzt wird. Das Folienlaminat steht randseitig über und kann mit diesen überstehenden Bereichen entweder an eine Leiterplatte oder an einen entsprechenden überstehenden Bereich eines Abschirm-Formteil-Gegenstückes angeschweißt oder -gelötet werden.

Aufgabe der vorliegenden Erfindung ist es, ein Abschirm-Formteil der im Oberbegriff des Anspruches 1 angegebenen Art so weiterzubilden, daß es eine zuverlässige mechanische und gleichzeitig gut leitfähige Verbindung mit einem Gegenstück eingehen kann.

Diese Aufgabe wird durch die im Anspruch 1 angegebene Erfindung gelöst.

Über die beanspruchte Durchgangsöffnungen werden elektrisch leitende Verbindungen zwischen den beiden gegenüberliegenden Seiten des Kontaktierungs- und Befestigungsflansches hergestellt werden.

Die letztere Möglichkeit wird bei derjenigen Ausgestaltung der Erfindung verwirklicht, bei welcher die Wandungen der Öffnungen in dem Kontaktierungs- und Befestigungsflansch metallische Beschichtungen aufweisen, über welche eine metallische Beschichtung auf der einen Seite des Kontaktierungs- und Befestigungsflansches mit einer Beschichtung auf der anderen Seite des Kontaktierungs- und Befestigungsflansches in Verbindung steht. Diese Bohrungen haben also den primären Sinn, die metallischen Beschichtungen auf beiden Seiten des Kontaktierungs- und Befestigungsflansches und damit auch auf beiden Seiten des Abschirm-Formteiles elektrisch miteinander in Verbindung zu bringen. Sind die erfindungsgemäßen Abschirm-Formteile so ausgestaltet, dann können sie ohne weiteres im "Mehrfachnutzen" hergestellt werden, ohne daß die wechselseitige elektrische Verbindung der metallischen Beschichtungen auf gegenüberliegenden Seiten verloren geht.

Eine besonders bevorzugte Grundform der erfindungsgemäßen Abschirm-Formteile ist diejenige, bei der das Abschirm-Formteil aus zwei Hälften zusammengesetzt ist, die entlang eines einstückig angeformten Scharniers miteinander verbunden sind. Die beiden Hälften des Abschirm-Formteiles können entlang des Scharnieres aus einer Offenstellung in eine Schließstellung und umgekehrt überführt werden. Die Beschickung des erfindungsgemäßen Abschirm-Formteiles erfolgt also bei dieser Ausgestaltung in der Offenstellung der beiden Hälften, die dann zum Betrieb des elektrischen Gerätes, zu dem die abgeschirmten Bauelemente gehören, geschlossen werden.

Zweckmäßiger Weise umfassen beide Hälften jeweils einen Kontaktierungs- und Befestigungsflansch, die in der Schließstellung eine elektrisch leitende Verbindung zwischen mindestens jeweils einer Beschichtung der beiden Hälften herstellen. Allerdings können die metallischen Beschichtungen der beiden Hälften auch über das die beiden Hälften miteinander verbindende Scharnier verbunden sein.

Bei der aus zwei Hälften zusammengesetzten Ausführungsform der Erfindung können die Kontaktierungs- und Befestigungsflansche der beiden Hälften durch eine Klebstoffschicht miteinander verbunden sein, die ggf. auch elektrisch leitend ist. Im allgemeinen empfiehlt es sich jedoch, daß die Kontaktierungs- und Befestigungsflansche der beiden Hälften lösbar miteinander verbunden sind.

In diesem Zusammenhang erweisen sich nunmehr die gemäß Anspruch 1 erfindungsgemäß vorhandenen Öffnungen in dem Kontaktierungs- und Befestigungsflansch erneut als nützlich: Es wird dann nämlich eine Ausgestaltung möglich, bei welcher einer der beiden Kontaktierungs- und Befestigungsflansche mit einer Mehrzahl elastisch verformbarer, einstückiger druckknopfartiger Erhebungen und der andere der beiden Kontaktierungs- und Befestigungsflansche mit einer entsprechenden Mehrzahl komplementärer Öffnungen versehen ist, durch welche die druckknopfartigen Erhebungen unter elastischer Verformung durchführbar sind.

Die Kontaktierungs- und Befestigungsflansche der beiden Hälften können in der Schließstellung unmittelbar aneinander anliegen. Das erfindungsgemäße Abschirm-Formteil umgibt in dieser Ausgestaltung eine im wesentlichen geschlossene Gruppe elektronischer Bauelemente, die dann allenfalls durch elektrische Verbindungsleitungen mit anderen Bauelementen verbunden ist.

Alternativ ist es jedoch auch möglich, daß zwischen den beiden Kontaktierungs- und Befestigungsflanschen der beiden Hälften eine die elektronischen Bauelemente tragende Leiterplatte angeordnet ist. Diese Leiterplatte läuft also zwischen den beiden Hälften des Abschirm-Formteiles hindurch und stellt die Außenverbindung her; sie bildet gleichzeitig den "Träger" für das Abschirm-Formteil.

Werden in diesem Falle die oben bereits erwähnten druckknopfartigen Erhebungen in einem Kontaktierungs- und Befestigungsflansch einer Hälfte eingesetzt, so können diese druckknopfartigen Erhebungen in der Schließstellung (auch) durch Bohrungen in der Leiterplatte hindurchgeführt sein. Auf diese Weise erfolgt die mechanische Festlegung des erfindungsgemäßen Abschirm-Formteiles an der Leiterplatte.

Im allgemeinen empfiehlt es sich, daß die druckknopfartigen Erhebungen eine metallische Beschichtung tragen, über welche in der Schließstellung mindestens eine metallische Beschichtung der einen Hälfte mit mindestens einer metallischen Beschichtung der anderen Hälfte elektrisch in Verbindung steht. Die druckknopfartigen Erhebungen stellen in diesem Falle nicht nur den elektrischen Kontakt zwischen den Beschichtungen der beiden Hälften des Abschirm-Formteiles her; sondern sie dichten - sofern der Abstand der druckknopfartigen Erhebungen nicht zu groß ist - auch den Spalt zwischen den beiden Hälften häufig in ausreichendem Maße gegen das Eindringen von Störstrahlung ab. Selbstverständlich ist es aber möglich, hier ggf. zusätzlich noch elastische, ggf. leitfähige Dichtungen einzusetzen.

Werden die durckknopfartigen Erhebungen in der geschilderten Weise zur Fixierung des Abschirm-Formteiles an einer Leiterplatte eingesetzt, so ist häufig der weitergehende Schritt vorteilhaft, daß die druckknopfartigen Erhebungen auch durch Bohrungen in der Leiterbahn auf der Leiterplatte derart hindurchgeführt sind, daß ihre metallische Beschichtung elektrisch mit der Leiterbahn in Verbindung steht. Die druckknopfartigen Erhebungen besorgen auf diese Weise die elektrische Masseverbindung der metallischen Beschichtungen auf den beiden Hälften des Abschirm-Formteiles, die für eine effiziente Abschirmung der Störstrahlung unentbehrlich ist.

Die metallische Beschichtung des Abschirm-Formteiles geschieht vorzugsweise durch
a) Besprühen des Kunststoff-Formteiles mit einem Metallpartikel enthaltenden Lack ohne Maskierung von einer Seite her, wodurch sich auf der einen Seite des Kunststoff-Formteiles, auf den Wandungen der Öffnungen und dem Bereich eines den Öffnungen benachbarten Saumes eine Lackschicht bildet;
b) chemogalvanische Metallisierung der Lackschicht.

Der besondere Vorteil dieser Art der Herstellung der Beschichtung besteht darin, daß sich der den Öffnungen benachbarte Saum auf der "Gegenseite" des Kontaktierungs- und Befestigungsflansches (also der nicht direkt angespritzten Seite) "automatisch" ergibt, ohne daß das Abschirm-Formteil gewendet und auch von der gegenüberliegenden Seite besprüht werden müßte. Der sich bildende Saum auf der "Gegenseite" reicht aus, in der erforderlichen Weise eine elektrische Verbindung zu einem benachbarten Bauteil herzustellen.

Ausführungsbeispiele der Erfindung werden nachfolgend anhand der Zeichnung näher erläutert; es zeigen
- Figuren 1a u. 1b: ein zweiteiliges, mit Scharnier versehenes Abschirm-Formteil in der Schließ- bzw. in der Offenstellung;
- Figur 2: einen vergrößerten Teilschnitt durch Befestigungsmittel, wie sie bei dem Abschirm-Formteil der Figuren 1a und 1b Verwendung finden;
- Figur 3: einen Schnitt, ähnlich der Figur 2, in der jedoch die beiden Hälften des Abschirm-Formteiles eine elektronische Leiterplatte einschließen;
- Figur 4: perspektivisch ein weiteres Ausführungsbeispiel einer Abschirmkappe;
- Figur 5: in vergrößertem Maßstab einen Teilschnitt durch den Kontaktierungs- und Befestigungsflansch der Abschirmkappe von Figur 4;
- Figur 6: einen Teilschnitt, ähnlich der Figur 6, durch ein weiteres Ausführungsbeispiel eines Kontaktierungs- und Befestigungsflansches.

Bei dem in den Figuren 1a und 1b dargestellten Ausführungsbeispiel ist ein Abschirm-Formteil 211 aus zwei Hälften 211', 211'' zusammengesetzt, die über ein einstückig angeformtes flexibles Scharnier 221 miteinander in Verbindung stehen.

Jede der beiden Hälften 211', 211'' des Abschirm-Formteiles 211 umfaßt ein etwa quaderförmig ausgebildetes Kunststoff-Formteil 212', 212'', an das jeweils ein Kontaktierungs- und Befestigungsflansch 217', 217'' angeformt ist. Das die beiden Hälften 211', 211'' verbindende flexible Scharnier 221 befindet sich, wie der Figur 1b zu entnehmen ist, an einem gemeinsamen Rand der beiden Kontaktierungs- und Befestigungsflansche 217', 217''.

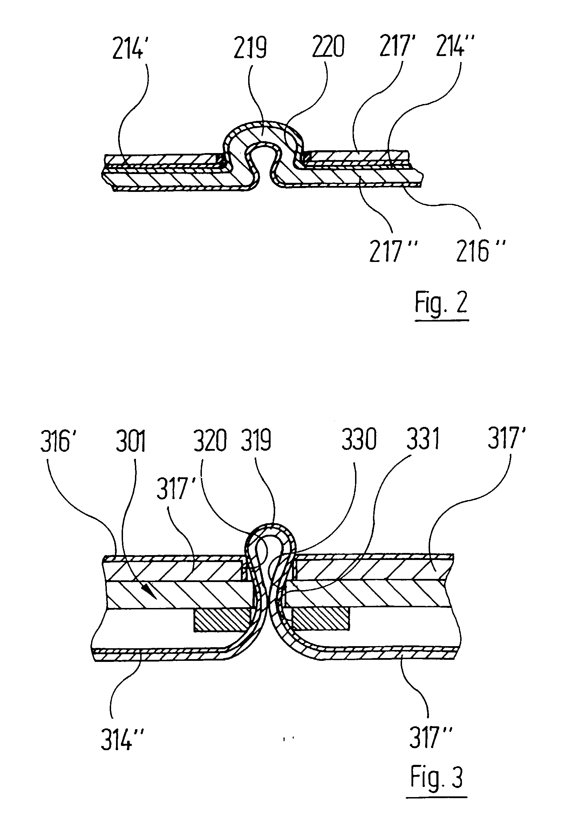

Die beiden Kontaktierungs- und Befestigungsflansche 217', 217'' der beiden Hälften 211', 211'' sind mit komplementären Befestigungsmitteln 219, 220 versehen, von denen ein Paar in Figur 2 in größerem Maßstab herausgezeichnet ist.

Die Befestigungsmittel 219 am Kontaktierungs- und Befestigungsflansch 217'' der in Figur 1b rechten Hälfte 211'' sind jeweils als einstückig an diesen Kontaktierungs- und Befestigungsflansch 217'' angeformte, elastische druckknopfartige Erhebungen ausgestaltet, während die Befestigungsmittel 220 am Kontaktierungs- und Befestigungsflansch 217' der anderen Hälfte 211' komplementäre Öffnungen sind. Die Druckknöpfe 219 können einfach durch die entsprechenden Öffnungen 220 mit einer gewissen Kraftentfaltung hindurchgedrückt werden, wodurch dann die beiden Kontaktierungs- und Befestigungsflansche 217', 217'' lösbar aneinander befestigt sind (Figur 1a).

Wie der Figur 2 zu entnehmen ist, ist der Kontaktierungs- und Befestigungsflansch 217'' der in Figur 1b rechten Hälfte 211'' sowohl auf der Innenwandung mit einer metallischen Beschichtung 214'' als auch auf der Außenwandung mit einer metallischen Beschichtung 216'' versehen. Diese Beschichtungen 214'' und 216'' finden sich auch im Bereich der Druckknöpfe 219.

Der Kontaktierungs- und Befestigungsflansch 217' der in Figur 1b linken Hälfte 211' dagegen ist nur auf seiner Innenwandung mit einer metallischen Beschichtung 214' versehen, die sich allerdings in die Mantelflächen der Öffnungen 220 hinein erstreckt.

Das in den Figuren 1a und 1b dargestellte Abschirm-Formteil 211 wird wie folgt eingesetzt:

Die abzuschirmenden elektronischen Bauelemente, die in diesem Falle nicht unbedingt auf einer elektronischen Leiterplatte angeordnet zu sein brauchen, werden in das Abschirm-Formteil 211 in dem in Figur 1b dargestellten aufgeklappten Zustand ("Offenstellung") eingebracht. Sodann wird die eine Hälfte 211' entlang des Scharniers 221 über die andere Hälfte 211'' geklappt; die Druckknöpfe 220 am Kontaktierungs- und Befestigungsflansch 217'' werden in die entsprechenden Öffnungen 220 der anderen Hälfte 211' eingedrückt, wodurch die in Figur 1a dargestellte Schließstellung erreicht wird. Zwischen den metallischen Beschichtungen 214' und 214'' der Kontaktierungs- und Befestigungsflansche 217', 217'' wird einerseits durch die direkte flächige Aneinanderlage, insbesondere aber auch durch die Berührung im Bereich der Druckknöpfe 219 und der Öffnungen 220 eine elektrische Verbindung hergestellt, so daß insgesamt der Innenraum des geschlossenen Abschirm-Formteiles 211 vollständig von einer Metallisierung umgeben ist.

Der Abstand benachbarter Befestigungsmittel-Paare 219, 220 an den Kontaktierungs- und Befestigungsflanschen 217', 217'' wird auf die Frequenz der abzuschirmenden Strahlung so abgestimmt, daß ein Eindringen von elektromagnetischer Strahlung in den Innenraum des Abschirm-Formteiles 211 vollständig unterbunden ist.

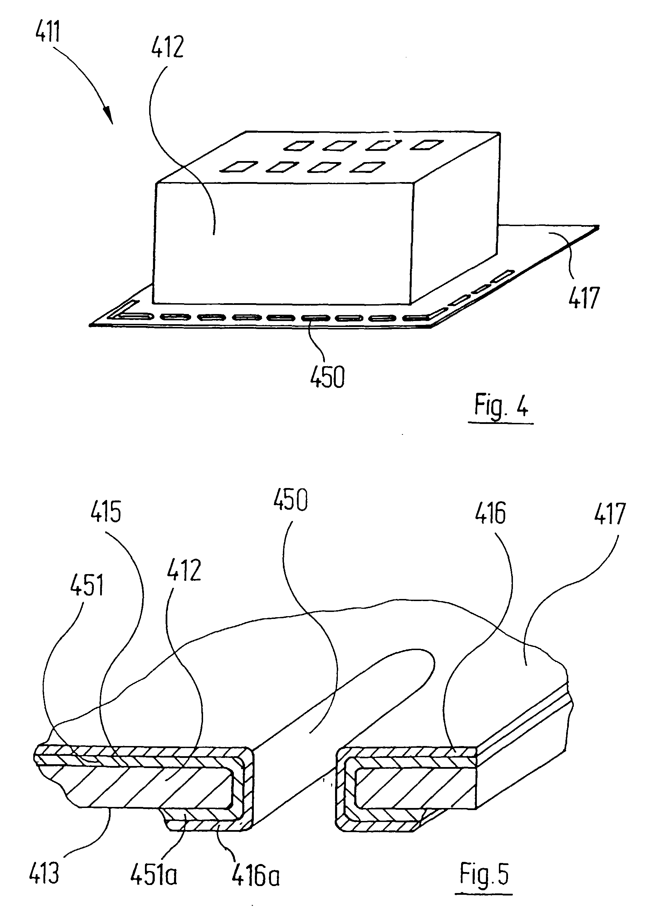

Figur 3 zeigt eine Variante des Abschirm-Formteiles der Figuren 1a und 4b, welche zusammen mit einer elektronischen Leiterplatte eingesetzt wird. Entsprechende Teile in Figur 3, die einen Schnitt ähnlich der Figur 2 darstellt, sind mit denselben Bezugszeichen wie in Figur 2, jedoch um 100 erhöht, versehen.

In Figur 3 sind wiederzuerkennen: die Kontaktierungs- und Befestigungsflansche 317', 317'' der beiden Hälften des Abschirm-Formteiles, ein als elastisch federnder Druckknopf 319 ausgebildetes Befestigungsmittel an dem Kontaktierungs- und Befestigungsflansch 317'', eine entsprechende Öffnung 320 an dem anderen Kontaktierungs- und Befestigungsflansch 317'', eine metallische Beschichtung 314'' an der Innenwandung des einen Kontaktierungs- und Befestigungsflansches 317'' sowie eine metallische Beschichtung 316' an der Außenwandung des anderen Kontaktierungs- und Befestigungsflansches 317', die bis in die Öffnung 320 hineinreicht.

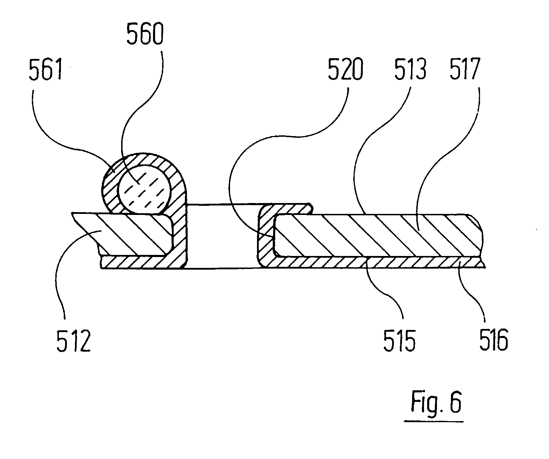

Zwischen den beiden Kontaktierungs- und Befestigungsflanschen 317'. 317'' ist nun zusätzlich eine elektronische Leiterplatte 301 angeordnet, welche die abzuschirmenden Bauelemente (nicht dargestellt) trägt. Die Leiterplatte 301 ist mit Durchgangsöffnungen 330 versehen, welche von den Druckknöpfen 319 in der Schließstellung des Abschirm-Formteiles durchsetzt werden, wie dies in Figur 6 dargestellt ist. Außerdem trägt die Leiterplatte 301 eine auf Massepotential liegende Leiterbahn 302, die ebenfalls mit Öffnungen 331 versehen ist, durch welche in der Schließstellung jeweils ein Druckknopf 319 hindurchgeführt ist.

Wie bei Betrachtung der Figur 3 ohne weiteres deutlich wird, ist bei dem hier dargestellten Ausführungsbeispiel des Abschirm-Formteiles durch die komplementären Druckknöpfe 319 bzw. Öffnungen 320 nicht nur eine elektrisch leitende Verbindung zwischen den metallischen Beschichtungen 314'' und 316' der beiden Hälften hergestellt. Darüber hinaus berührt die metallische Beschichtung 314'' im Bereich der Druckknöpfe 319 auch die auf Massepotential liegende Leiterbahn 302 und bewirkt auf diese Weise die erforderliche Erdung der die eigentliche Abschirmfunktion übernehmenden metallischen Beschichtungen 314'' und 316'. Durch die komplementären Befestigungsmittel 319 und 320 werden bei diesem Ausführungsbeispiel die beiden Hälften des Abschirm-Formteiles nicht nur aneinander sondern auch an der elektronischen Leiterplatte 301 befestigt. Für den Abstand benachbarter Paare von komplementärer Befestigungsmittel 319, 320 gilt beim Ausführungsbeispiel von Figur 3 dasselbe, was oben für das Ausführungsbeispiel von Figur 2 gesagt wurde.

Selbstverständlich kann auch bei der aus zwei Hälften zusammengesetzten Ausführungsform eines Abschirm-Formteiles statt der lösbaren Befestigungsmittel 219, 220 bzw. 319, 320 eine elektrisch leitende, elastische Dicht- und Klebmasse eingesetzt werden, die punktförmig oder strangartig mit Unterbrechungen aufgetragen wird und entweder an beiden Kontaktierungs- und Befestigungsflanschen oder auch nur an einem fest anhaftet. Auch hier wird der Abstand benachbarter Dicht- und Klebemassestränge an die Frequenz des abzuschirmenden Strahlungsspektrumes angepaßt. Dabei bedarf es keines besonderen Hinweises, daß die soeben erwähnten, in der Zeichnung nicht dargestellten Dicht- und Klebemassen auch mit den lösbaren Befestigungsmitteln der Figuren 2 und 3 kombiniert werden können.

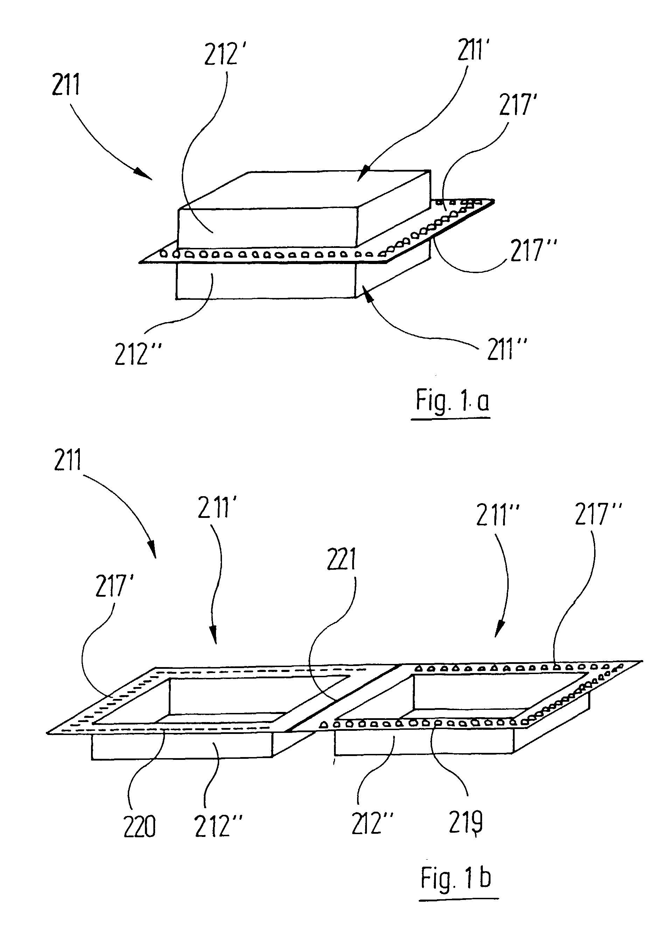

Das in den Figuren 4 und 5 dargestellte Ausführungsbeispiel eines Abschirm-Formteiles ist als einseitig an einer elektronischen Leiterplatte anzubringende Abschirmkappe ausgestaltet. Es läßt sich jedoch auch als eine Hälfte eines zweiteiligen Abschirm-Formteiles, entsprechend den Figuren 1a und 1b verstehen. Entsprechende Teile in Figuren 4 und 5 sind erneut mit denselben Bezugszeichen wie in Figur 1, jedoch zuzüglich 200, gekennzeichnet. Das Ausführungsbeispiel der Figuren 4 und 5 unterscheidet sich von den zuvor beschriebenen Ausführungsbeispielen in zweierlei Hinsicht:

Erstens ist das in diesem Ausführungsbeispiel wiederum quaderförmige Kunststoff-Formteil 412 an seiner Oberseite mit einer Vielzahl von Durchbrüchen 440 versehen. Über diese können die im Inneren der Abschirmkappe 411 untergebrachten elektronischen Bauelemente nachträglich mit Hilfe eines Schraubendrehers oder eines entsprechenden Werkzeuges manipuliert werden, ohne daß die Abschirmkappe 411 von der Leiterplatte abgenommen werden müßte. Die Durchbrüche 440 dienen auch der Durchführung von elektrischen Verbindungsleitungen oder Steckkontakten (nicht dargestellt) und ermöglichen die Luftzirkulation.

Der zweite Unterschied betrifft die Art der metallischen Beschichtung 416, die beim Ausführungsbeispiel der Figuren 4 und 5 über der gesamten Außenwand angebracht ist, sowie das Verfahren zu deren Aufbringung. Die Verhältnisse werden insbesondere anhand von Figur 5 deutlich, welche in vergrößertem Maßstab einen Teilschnitt durch einen Bereich des Kontaktierungs- und Befestigungsflansches 417 der Abschirmkappe 411 von Figur 4 darstellt.

Der gesamte Kontaktierungs- und Befestigungsflansch 417 wird von einer Reihe länglicher Öffnungen 450 durchsetzt, deren Sinn weiter unten deutlich werden wird. Die bereits angesprochene metallische Beschichtung 416 befindet sich beim Ausführungsbeispiel der Figuren 4 und 5 nicht unmittelbar auf dem Kunststoff-Material des Kunststoff-Formkörpers 412, sondern über einer geschlossenen, Metallpigmente enthaltenden Lackschicht 451. Die Aufbringung der metallischen Beschichtung 416 geschieht in diesem Falle wie folgt:

Die gesamte Außenfläche des Kunststoff-Formteiles 412 wird zunächst, z.B. in Figur 4 von oben her, mit dem Lack 451 bespritzt. Dieser dringt durch die Reihe von länglichen Öffnungen 450 auf die andere Seite des Kontaktierungs- und Befestigungsflansches 417 und schlägt sich in einem Lacksaum 451a auf der gegenüberliegenden Seite des Kontaktierungs- und Befestigungsflansches 417 nieder. Auch die Wandungen der Öffnungen 450 werden dabei mit einer Lackschicht belegt. Der überwiegende Bereich der Innenwandung des Kunststoff-Formteiles 412 bleibt jedoch lackfrei. Bei der nachfolgenden chemogalvanischen Metallisierung wird dann die eigentliche metallische Beschichtung 416 aufgebracht, die sich überall dort und nur dort abscheidet, wo zuvor eine Lackschicht 451 aufgebracht wurde. Dies bedeutet, daß die metallische Beschichtung 416 die gesamte Außenwand 415 des Kunststoff-Formteiles 412, die Wandungen der Öffnungen 450 und einen Saum 416a entlang der Öffnungen 450 bedeckt. Die auf der Außenwand 415 des Kunststoff-Formteiles 412 liegende metallische Beschichtung 416 steht also mit dem Saum 416a über die Mantelflächen der Öffnungen 450 elektrisch leitend in Verbindung. Dies hat den Vorteil, daß die Abschirmkappen 411 im Mehrfachnutzen hergestellt werden können: Die elektrisch leitende Verbindung über die Mantelflächen der Öffnungen 450 bleibt bei der Durchtrennung in einzelne Abschirmkappen 411 erhalten.

In Figur 6 schließlich ist der Kontaktierungs- und Befestigungsflansch 517 eine Abschirmkappe bzw. der Hälfte eines Abschirm-Formteiles dargestellt, welche der links in Figur 4b dargestellten Hälfte 211' des Abschirm-Formteiles 211 eng verwandt ist. Entsprechende Teile von Figur 6 sind mit demselben Bezugszeichen wie in Figur 1, jedoch zuzüglich 300, gekennzeichnet.

In Figur 6 sind wiederzuerkennen: der Kontaktierungs- und Befestigungsflansch 517 des Kunststoff-Formteiles 512, eine als Befestigungsmittel dienende Bohrung 520, eine auf der Außenwand 515 aufgebrachte metallische Beschichtung 516, welche durch die Bohrung 520 hindurchreicht und rechts von der Bohrung 520 auf der Innenwand 513 des Kontaktierungs- und Befestigungsflansches 517 einen Saum bildet.

Neu in Figur 6 ist ein geschlossen umlaufender, nicht metallhaltiger, elastischer Strang 560 aus Dichtmaterial. Dieser Strang ist seinerseits mit einer metallischen Beschichtung 561 versehen, welche über die Bohrungen 520 hinweg mit der metallischen Beschichtung 516 in Verbindung steht. Die Hochfrequenz-Dichtheit im Spalt zwischen dem Kontaktierungs- und Befestigungsflansch 517 und dem Bauteil, an welchem dieser Kontaktierungs- und Befestigungsflansch 517 befestigt wird (z.B. einer elektronischen Leiterplatte oder an einer zweiten Hälfte des entsprechenden Abschirm-Formteiles) wird also bei diesem Ausführungsbeispiel durch die metallische Beschichtung 561 auf dem Dichtstrang 560 bewirkt. Selbstverständlich kann dieser selbst elektrisch nicht leitende Dichtstrang 560 mit nachträglicher metallischer Beschichtung 561 auch bei anderen Befestigungsarten des Abschirm-Formteiles (ohne Druckknöpfe und komplementäre Löcher) eingesetzt werden, z.B. bei einer Verklebung.

## Patentansprüche

1. Abschirm-Formteil für elektronische Bauelemente mit mindestens einer elektrisch leitfähigen, elektromagnetische Felder und Strahlung abschirmenden Schicht, welches aus einem thermoplastisch verformbaren Kunststoff-Formteil (212; 312; 412; 512) besteht und auf der Innenwand (213; 313; 413; 513) und/oder der Außenwand (215; 315; 415; 515) ganz oder teilweise mit einer elektrisch leitenden Beschichtung (214, 216; 314, 316; 414, 416; 514, 516) versehen ist,
dadurch gekennzeichnet, daß das Kunststoff-Formteil (212; 312; 412; 512) an seinen äußeren Randbereichen als umlaufender Kontaktierungs- und Befestigungsflansch (217; 317; 417; 517) ausgestaltet ist, der eine Mehrzahl von Durchgangsöffnungen (220; 320; 450; 520) aufweist.

2. Abschirm-Formteil nach Anspruch 1, dadurch gekennzeichnet, daß die Wandungen der Öffnungen (450) in dem Kontaktierungs- und Befestigungsflansch (417) metallische Beschichtungen aufweisen, über welche eine metallische Beschichtung (416) auf der einen Seite des Kontaktierungs- und Befestigungsflansches (417) mit einer metallischen Beschichtung (416a) auf der anderen Seite des Kontaktierungs- und Befestigungsflansches (417) in Verbindung steht.

3. Abschirm-Formteil nach Anspruch 1 oder 2, dadurch gekennzeichnet, daß es aus zwei Hälften (211', 211'') zusammengesetzt ist, die entlang eines einstückig angeformten Scharniers (220) miteinander verbunden sind.

4. Abschirm-Formteil nach Anspruch 3, dadurch gekennzeichnet, daß beide Hälften (211', 211''; 31', 311'') jeweils einen Kontaktierungs- und Befestigungsflansch (217', 217''; 317', 317'') aufweisen, die in einer Schließstellung eine elektrisch leitende Verbindung zwischen jeweils mindestens einer metallischen Beschichtung (214', 214'', 216'; 314, 316) der beiden Hälften (211', 211''; 311', 311'') herstellen.

5. Abschirm-Formteil nach Anspruch 4, dadurch gekennzeichnet, daß die Kontaktierungs- und Befestigungsflansche der beiden Hälften durch eine Klebstoffschicht miteinander verbunden sind.

6. Abschirm-Formteil nach Anspruch 5, dadurch gekennzeichnet, daß die Klebstoffschicht elektrisch leitend ist.

7. Abschirm-Formteil nach einem der vorhergehenden Ansprüche, dadurch gekennzeichnet, daß die Kontaktierungs- und Befestigungsflansche (217', 217''; 317', 317'') der beiden Hälften (211', 211''; 311', 311'') lösbar miteinander verbunden sind.

8. Abschirm-Formteil nach Anspruch 7, dadurch gekennzeichnet, daß einer der beiden Kontaktierungs- und Befestigungsflansche (217'; 317') mit einer Mehrzahl elastisch verformbarer, einstückiger druckknopfartiger Erhebungen (219'; 319) und der andere der beiden Kontaktierungs- und Befestigungsflansche (217''; 317'') mit einer entsprechenden Mehrzahl komplementärer Öffnungen (220; 320) versehen ist, durch welche die druckknopfartigen Erhebungen (219'; 319) unter elastischer Verformung durchführbar sind.

9. Abschirm-Formteil nach einem der Ansprüche 4 bis 7, dadurch gekennzeichnet, daß zwischen den beiden Kontaktierungs- und Befestigungsflanschen (17', 317'') der beiden Hälften (311', 311'') eine die elektronischen Bauelemente tragende Leiterplatte (301) angeordnet ist.

10. Abschirm-Formteil nach Anspruch 9 bei Rückbeziehung auf Anspruch 8, dadurch gekennzeichnet, daß die druckknopfartigen Erhebungen (319) in der Schließstellung durch Bohrungen (330) in der Leiterplatte (301) hindurchgeführt sind.

11. Abschirm-Formteil nach einem der Ansprüche 8 bis 10, dadurch gekennzeichnet, daß die druckknopfartigen Erhebungen (219; 319) eine metallische Beschichtung tragen, über welche mindestens eine metallische Beschichtung (214''; 314'') der einen Hälfte (211''; 311'') mit mindestens einer metallischen Beschichtung (214'; 316') der anderen Hälfte (211'; 311') elektrisch in Verbindung steht.

12. Abschirm-Formteil nach Anspruch 11 bei Rückbeziehung auf Anspruch 10, dadurch gekennzeichnet, daß die druckknopfartigen Erhebungen (319) durch Bohrungen (331) in einer elektrischen Leiterbahn (302) der Leiterplatte (01) derart hindurchgeführt sind, daß ihre metallische Beschichtung elektrisch mit der Leiterbahn (302) in Verbindung steht.

13. Verfahren zur Herstellung eines Abschirm-Formteiles nach Anspruch 2, dadurch gekennzeichnet, daß die metallische Beschichtung (416, 416a) in folgender Weise hergestellt wird:
a) Besprühen des Kunststoff-Formteiles (412) mit einem Metallpartikel enthaltenden Lack ohne Maskierung von einer Seite her, wodurch sich auf der einen Seite des Kunststoff-Formteiles (412), auf den Wandungen der Öffnungen (450) und im Bereich eines den Öffnungen (450) benachbarten Saumes auf der anderen Seite des Kunststoff-Formteiles (412) eine Lackschicht (451, 451a) bildet;
b) chemogalvanische Metallisierung der Lackschicht (451, 451a).

## Claims

1. Screening moulding for electronic components, having at least one electrically conductive layer that screens electromagnetic fields and radiation and that is composed of a thermoplastically deformable plastic moulding (212; 312; 412; 512) and is provided completely or partly with an electrically conducting coating (214, 216; 314, 316; 414, 416; 514, 516) on the internal wall (213; 313; 413; 513) and/or the external wall (215; 315; 415; 515),
characterized in that the plastic moulding (212; 312; 412; 512) is configured at its external peripheral regions as a circumferential contacting and mounting flange (217; 317; 417; 517) that has a plurality of through openings (220; 320; 450; 520).

2. Screening moulding according to Claim 1, characterized in that the walls of the openings (450) in the contacting and mounting flange (417) have metallic coatings via which a metallic coating (416) on the one side of the contacting and mounting flange (417) is connected to a metallic coating (416a) on the other side of the contacting and mounting flange (417).

3. Screening moulding according to Claim 1 or 2, characterized in that it is made up of two halves (211', 211") that are joined together along an integrally formed-on hinge (220).

4. Screening moulding according to Claim 3, characterized in that both halves (211', 211"; 311', 311") each have a contacting and mounting flange (217', 217"; 317', 317") that, in a closed position, make an electrically conducting connection between at least one metallic coating (214', 214", 216'; 314, 316) of each of the two halves (211', 211", 311', 311").

5. Screening moulding according to Claim 4, characterized in that the contacting and mounting flanges of the two halves are joined together with an adhesive layer.

6. Screening moulding according to Claim 5, characterized in that the adhesive layer is electrically conducting.

7. Screening moulding according to one of the preceding claims, characterized in that the contacting and mounting flange (217', 217"; 317', 317") of the two halves (211', 211"; 311', 311") are detachably joined to one another.

8. Screening moulding according to Claim 7, characterized in that one of the two contacting and mounting flanges (217'; 317') is provided with a plurality of elastically deformable, integral pushbutton-type elevations (219; 319) and the other of the two contacting and mounting flanges (217"; 317") is provided with a corresponding plurality of complementary openings (220; 320) through which the pushbutton-type elevations (219'; 319) can be passed with elastic deformation.

9. Screening moulding according to one of Claims 4 to 7, characterized in that a printed circuit board (301) carrying the electronic components is disposed between the two contacting and mounting flanges (317', 317") of the two halves (311', 311").

10. Screening moulding according to Claim 9 with reference back to Claim 8, characterized in that the pushbutton-type elevations (319) are passed through bores (330) in the printed circuit board (301) in the closed position.

11. Screening moulding according to one of Claims 8 to 10, characterized in that the pushbutton-type elevations (219; 319) carry a metallic coating via which at least one metallic coating (214"; 314") of the one half (211"; 311") is electrically connected to at least one metallic coating (214'; 316') of the other half (211'; 311').

12. Screening moulding according to Claim 11 with reference back to Claim 10, characterized in that the pushbutton-type elevations (319) are passed through bores (331) in an electrical conductor track (302) of the printed circuit board (301) in such a way that their metallic coating is electrically connected to the conductor track (302).

13. Method of producing a screening moulding according to Claim 2, characterized in that the metallic coating (416, 416a) is produced in the following manner:
a) spraying the plastic moulding (412) with a lacquer containing metallic particles without maskng from one side, as the result of which a lacquer layer (451, 451a) forms on the one side of the plastic moulding (412), on the walls of the openings (450) and in the region of a seam adjacent to the openings (450) on the other side of the plastic moulding (412);
b) electroless metallization of the lacquer layer (451, 451a).

## Revendications

1. Capot de blindage moulé pour composants électroniques, comprenant au moins une couche conductrice de courant protégeant des champs et du rayonnement électromagnétiques, qui est composé d'une pièce moulée en matière plastique thermoplastique (212 ; 312 ; 412 ; 512) et qui est muni sur la paroi intérieure (213 ; 313 ; 413 ; 513) et/ou sur la paroi extérieure (215 ; 315 ; 415 ; 515), en totalité ou en partie, d'un revêtement conducteur de courant (214, 216 ; 314, 316 ; 414, 416 ; 514, 516), caractérisé en ce que la pièce moulée en matière plastique (212 ; 312 ; 412 ; 512) est réalisée, au niveau de ses bords extérieurs, sous la forme d'une bride de contact et de fixation (217 ; 317 ; 417 ; 517) présentant une multitude d'ouvertures (220 ; 320 ; 450 ; 520).

2. Capot de blindage moulé selon la revendication 1, caractérisé en ce que les parois des ouvertures (450) comportent, dans la bride de contact et de fixation (417), des revêtements métalliques par le biais desquels un revêtement métallique (416) sur l'une des faces de la bride de contact et de fixation (417) est relié à un revêtement métallique (416a) sur l'autre face de la bride de contact et de fixation (417).

3. Capot de blindage moulé selon la revendication 1 ou 2, caractérisé en ce qu'il est constitué par deux moitiés (211', 211") reliées l'une à l'autre le long d'une charnière (220) moulée et formant une seule pièce avec celles-ci.

4. Capot de blindage moulé selon la revendication 3, caractérisé en ce que les deux moitiés (211', 211" ; 311', 311") présentent chacune une bride de contact et de fixation (217', 217" ; 317', 317") qui, dans une position fermée, établissent une liaison conductrice de courant entre chaque fois au moins un revêtement métallique (214', 214", 216' ; 314, 316) des deux moitiés (211', 211" ; 311', 311").

5. Capot de blindage moulé selon la revendication 4, caractérisé en ce que les brides de contact et de fixation des deux moitiés sont reliées entre elles par une couche de colle.

6. Capot de blindage moulé selon la revendication 5, caractérisé en ce que la couche de colle est conductrice de courant.

7. Capot de blindage moulé selon l'une des revendications précédentes, caractérisé en ce que les brides de contact et de fixation (217', 217" ; 317', 317") des deux moitiés (211', 211"; 311', 311") sont assemblées de façon amovible.

8. Capot de blindage moulé selon la revendication 7, caractérisé en ce que l'une des deux brides de contact et de fixation (217', 317') est munie d'un grand nombre d'élévations semblables à des boutons-pression (219'; 319) d'une seule pièce et déformables élastiquement et l'autre des deux brides de contact et de fixation (217" ; 317") est munie d'un nombre correspondant d'orifices complémentaires (220 ; 320) à travers lesquels les élévations semblables à des boutons-pression (219'; 319) peuvent passer en se déformant élastiquement.

9. Capot de blindage moulé selon l'une des revendications 4 à 7, caractérisé en ce qu'entre les deux brides de contact et de fixation (217', 317") des deux moitiés (311', 311") est disposée une plaquette de circuits imprimés (301) portant les composants électroniques.

10. Capot de blindage moulé selon la revendication 9 en référence à la revendication 8, caractérisé en ce qu'en position de fermeture, les élévations semblables à des boutons-pression (319) passent à travers des perçages (330) dans la plaquette de circuits imprimés (301).

11. Capot de blindage moulé selon l'une des revendications 8 à 10, caractérisé en ce que les élévations semblables à des boutons-pression (219 ; 319) portent un revêtement métallique par le biais duquel au moins un revêtement métallique (214" ; 314") de l'une des moitiés (211" ; 311") est relié électriquement à au moins un revêtement métallique (214' ; 316') de l'autre moitié (211' ; 311').

12. Capot de blindage moulé selon la revendication 11 en référence à la revendication 10, caractérisé en ce que les élévations semblables à des boutons-pression (319) traversent des perçages (331) d'un circuit imprimé (302) d'une plaquette de circuits imprimés (301) de telle manière que leur revêtement métallique est relié électriquement au circuit imprimé (302).

13. Procédé pour fabriquer un capot de blindage moulé selon la revendication 2, caractérisé en ce que le revêtement métallique (416, 416a) est fabriqué de la manière suivante :
a) aspersion de la pièce moulée en matière plastique (412) avec un vernis contenant des particules métalliques, sans masquage et par un côté, ce qui forme une couche de vernis (451, 451a) sur l'une des faces de la pièce moulée en matière plastique (412), sur les parois des orifices (450) et dans la zone d'une bordure adjacente aux orifices (450) qui se situe sur l'autre face de la pièce moulée en matière plastique (412) ;
b) métallisation par galvanisation chimique de la couche de vernis (451, 451a).
